# EUROPEAN PATENT APPLICATION

(11) **EP 4 803 478 A1**
(43) Date of publication of application: **09.09.2026**
(21) Application number: 24890539.0
(22) Date of filing: 06.11.2024
(51) Int. Cl.: B81B 7/02

(54) **AREA ARRAY-LEVEL PACKAGED UNCOOLED INFRARED DETECTOR AND PREPARATION METHOD THEREFOR**

(30) Priority: 13.11.2023 CN 202311505995
(71) Applicant: Wuhan Global Sensor Technology Co., Ltd., Wuhan, Hubei 430205 (CN)
(72) Inventor: HUANG, Cheng, Wuhan, Hubei 430205 (CN); HUANG, Li, Wuhan, Hubei 430205 (CN); JIANG, Zhixing, Wuhan, Hubei 430205 (CN); YE, Fan, Wuhan, Hubei 430205 (CN); WANG, Chunshui, Wuhan, Hubei 430205 (CN); WANG, Chao, Wuhan, Hubei 430205 (CN); WANG, Yaqin, Wuhan, Hubei 430205 (CN); WANG, Jiawei, Wuhan, Hubei 430205 (CN); FANG, Ming, Wuhan, Hubei 430205 (CN)
(74) Representative: Neves, Ana
(86) International application number: PCT/CN2024/130087
(87) International publication number: WO 2025/103182

(57) **Abstract**

The invention discloses an array level packaged uncooled infrared detector and its preparation method thereof, and relates to the field of detectors. The array level packaged uncooled infrared detector includes a read-out circuit substrate and active elements arranged on the upper surface of the read-out circuit substrate and electrically connected with the read-out circuit substrate. The array level packaged uncooled infrared detector also includes a getter deposition area. The array level packaged uncooled infrared detector opens up a separate area for the getter body, and deposits the getter body after the release of the structural sacrifice layer, avoiding the impact of high temperature and organic solution in the process of mems technology on the performance of the getter body, and adopts thermal activation. The activation mode of the getter body is simple, and it is easy to carry out batch production and manufacturing.

## Description

### Technical Field

The invention relates to the technical field of detectors, in particular to an array level packaged uncooled infrared detector and its preparation method thereof.

### Background Technology

Uncooled infrared focal plane detectors are used to image by absorbing infrared energy from the outside world and converting it into electrical signals in an ultra-high vacuum environment. In the production of uncooled infrared detectors, getters must be used and activated in a vacuum sealed environment of the detector, so as to remove residual gas to maintain a higher vacuum. At the same time, if the vacuum degree decreases in the later use of the detector, the secondary activation of the getter can be carried out to absorb the residual gas, so that the detector can maintain a high vacuum environment again.

At present, the packaging methods of uncooled infrared detectors mainly include metal, ceramic, Wafer level and Pixel level packaging, in which metal and ceramic packaging uses cylindrical getters, which are soldered to the shell leads by welding, and electrically activated or heat activated getters are used to maintain high vacuum before packaging. Wafer level packaging uses thin film getters, which integrate getters onto cap Wafers, and finally activate getters by means of thermal activation with the high temperature of bonding at the time of bonding, so as to avoid the impact of temperature on getters during the preparation of chips in the mems process. Pixel level packaging refers to the integration of a capping chip and a mems chip on the basis of a Wafer level packaging, and the use of a material to directly package the whole surface of a mems micro structure. Based on this packaging form, the getter needs to be integrated into the whole micro cavity structure. The scheme reported at this stage is to place the getter at the bottom of the infrared microbolometer, which belongs to the deposition of getter in the previous process of mems. However, the multiple high temperature baking and organic solution cleaning processes involved in the conventional semiconductor process will affect the performance of the getter, and at the same time After the structure is completed, the sacrificial layer in the structure will be removed through the release of oxygen in a high temperature environment, in which the getter will be activated in advance, resulting in the loss of inspiration capacity, the inability to ensure the vacuum degree in the cavity, and the poor vacuum life of the detector. Therefore, it is necessary to re-design the structural layout and preparation method of getter to ensure the performance of getter, so that the getter can be fully activated and play the role of inspiration. In view of the shortcomings of the prior art, the present invention provides a plane array level packaged uncooled infrared detector and its preparation method to solve the above problems.

### Summary of the invention

### (1) Technical problems solved

In view of the shortcomings of the prior art, the present invention provides an array level packaged uncooled infrared detector and its preparation method, which opens up a separate area for the getter body, deposits the getter body after the release of the structural sacrifice layer, and designs the preparation process of the getter body at the last stage of the whole set of mems processes, so as to avoid the impact of the previous processes on the getter body, that is, to avoid the impact of high temperature and organic solution in the process of mems technology on the performance of the getter body, and to adopt thermal activation. The activation mode of the getter body is simple and easy to batch production and manufacture.

### (2) Technical Proposal

To achieve the above purposes, the present invention is realized through the following technical schemes:
A plane array level packaged uncooled infrared detector, including a read-out circuit substrate, on which a pixel area is provided, and an active element electrically connected with the read-out circuit substrate is provided, is characterized in that: the read-out circuit substrate is also provided with an getter deposition area, the getter deposition area is provided with an getter body, the top of the read-out circuit substrate is provided with a structural cavity, the structural cavity is provided with a release hole, and the getter body is corresponding to the release hole located above the getter deposition area.

Preferably, the top of the structural cavity is provided with a sealing film blocking the release hole, and a vacuum cavity is formed between the read-out circuit substrate, the structural cavity and the sealing film.

Preferably, the release hole includes a first release hole located above the pixel area and a second release hole located above the getter deposition area, the second release hole being larger than the first release hole, and the getter body one-to-one corresponding to the location and shape of the second release hole.

A method for preparing an array level packaged uncooled infrared detector includes the following steps:
S1: Divide the cell area and getter deposition area on the read-out circuit substrate, prepare the active element through the sacrificial layer in the cell area on the read-out circuit substrate, and make a structural cavity covered on the read-out circuit substrate, and make a sacrificial layer release hole on the structural cavity to complete the release of the sacrificial layer;
S2: shielding the release hole located above the pixel area, and only opening the release hole located above the getter deposition area;
S3: The getter material is deposited on the structure fabricated in step S2, and the getter material is deposited into the getter deposition area through the release hole above the getter deposition area, forming the getter body;
S4: After the main body of the getter is deposited, open the release hole located above the pixel area;
S5: The sealing hole film is plated on the structural cavity to complete the sealing of the vacuum cavity, and the getter body is activated by heating.

Preferably, when the getter body is placed in the getter deposition area, a shielding baffle is arranged on the top of the structural cavity to block the release hole above the pixel area, and when the getter body is deposited into the getter deposition area through the release hole above the getter deposition area, the shielding baffle is removed and the vacuum cavity is sealed with a hole sealing film.

Preferably, the sealing film is an infrared antireflection film.

Preferably, the structural cavity and the shielding baffle are combined by means of temporary bonding.

Preferably, the getter body adopts a physical vapor deposition process when depositing in the getter deposition area.

Preferably, the hole sealing film is coated on the structural cavity by an electron beam evaporation coating process.

Preferably, the getter deposition area is disposed within the vacuum cavity.

The present invention discloses an array level packaged uncooled infrared detector and its preparation method, which have the following beneficial effects:
1.The array level packaged uncooled infrared detector, which opens up a separate area for the getter body, deposits the getter body after the release of the structural sacrifice layer. and designs the preparation process of the getter body at the last stage of the whole set of mems processes, so as to avoid the impact of the previous processes on the getter body, that is, to avoid the impact of high temperature and organic solutions in the mems process on the performance of the getter body, and to adopt thermal activation. The activation mode of the getter body is simple and easy to carry out batch production and manufacture.
2.The array level packaged uncooled infrared detector conveniently blocks the first release hole through the shielding baffle, so as to facilitate the positioning and deposition of the getter main body through the release hole, and complete the positioning of the getter main body. After the shielding baffle completes the positioning and deposition of the getter main body after temporary bonding, it is convenient to remove and use the sealing film coating to complete the sealing of the vacuum chamber.
3. The array level packaged uncooled infrared detector adopts the electron beam evaporation coating process when the sealing film is deposited on the structural cavity. Unlike the traditional evaporation method, the electron beam evaporation method uses the electromagnetic field to bombard the target in the Crucible accurately, so as to melt it and deposit it on the substrate. The electron beam evaporation can deposit high-purity and high-accuracy films, so as to ensure the good effect of the sealing film.

### Description of attached drawings

In order to more clearly explain the embodiment of the invention or the technical solution in the prior art, the drawings required to be used in the embodiment or the description of the prior art will be briefly introduced below. Obviously, the drawings in the following description are only some examples of the invention. For those skilled in the art, other drawings may also be obtained from these drawings without creative labor.
Figure 1 is a schematic diagram of the overall structure of the invention;
Figure 2 is an initial schematic diagram of the getter deposition area of the invention;
Figure 3 is a structural schematic diagram of the shielding baffle of the present invention;
Figure 4 is a schematic diagram of the getter deposition of the invention;
Figure 5 is a schematic diagram of the removal of the shielding baffle of the present invention;
Figure 6 is a schematic diagram of the hole sealing film layer of the present invention.

In the figure: 1. Read-out circuit substrate; 2. Valid yuan; 3. Getter deposit area; 301. getter body; 302. Second release hole; 4. Structural cavity; 401. First release hole; 5. Sealing film; 6. Vacuum chamber; 7. Sheltering baffles.

### Specific implementation methods

In order to make the purposes, technical schemes and advantages of the embodiment of the invention clearer, the technical schemes in the embodiment of the invention are described clearly and completely. Obviously, the described embodiment is part of the embodiment of the invention, not all of the embodiment. Based on the examples in the invention, all other examples obtained by ordinary technicians in the art without creative work fall within the scope of protection of the invention.

By providing an array level packaged uncooled infrared detector and its preparation method, the embodiment of this application solves the problem that the existing scheme at this stage is to place the getter at the bottom end of the infrared microbolometer, which belongs to the deposition of the getter in the previous process of the mems, but the multiple high temperature baking and organic solution cleaning processes involved in the conventional semiconductor process will affect the performance of the getter. At the same time, after the completion of the mems structure, the sacrificial layer in the structure will be removed through the release of oxygen in a high temperature environment, and the getter will be activated in advance in this environment, resulting in the loss of getter capacity, the inability to ensure the vacuum degree in the cavity, and the problem of poor vacuum life of the detector.

In order to better understand the above technical scheme, the following will give a detailed description of the above technical scheme in combination with the drawings of the description and the specific implementation methods.

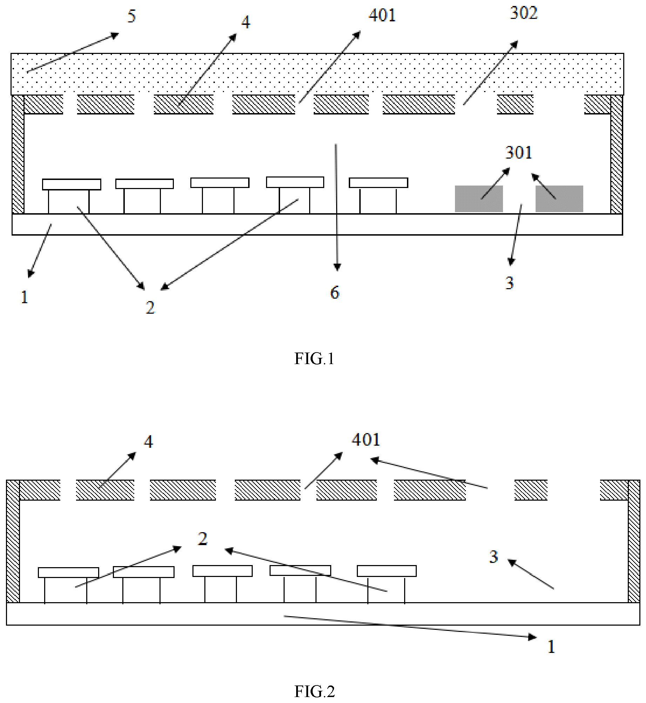

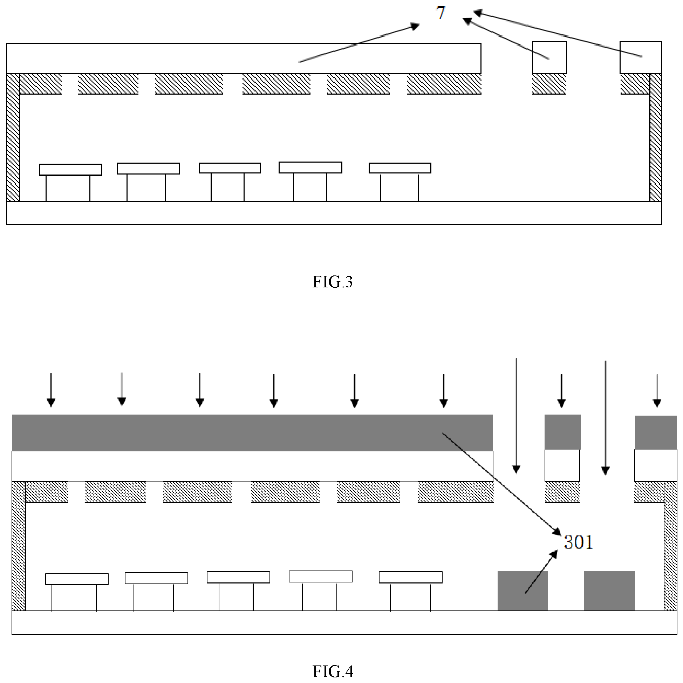

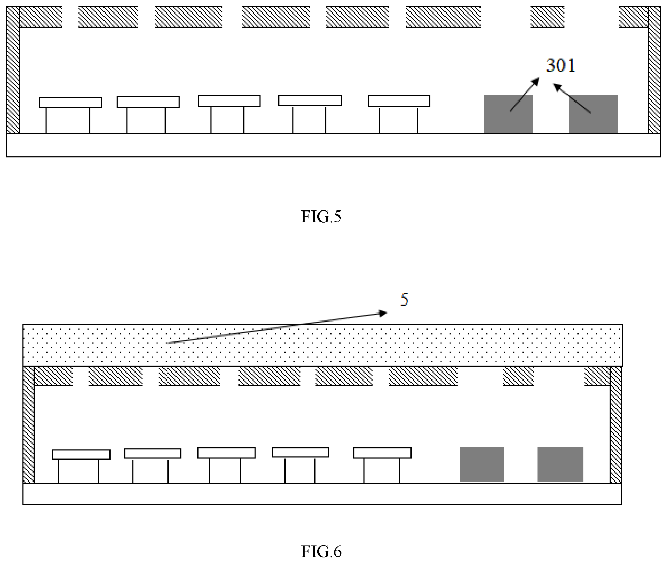

The embodiment of the present invention discloses an array level packaged uncooled infrared detector, which comprises a read-out circuit substrate 1 as shown in Figures 1-6, the read-out circuit substrate 1 having a pixel area, the pixel area having an effective element 2 electrically connected with the read-out circuit substrate 1, the read-out circuit substrate 1 also having an getter deposition area 3, the getter deposition area 3 having an getter body 301, the top of the read-out circuit substrate 1 having a structural cavity 4, the structural cavity 4 having a release hole, and the getter body 301 corresponding to the release hole above the getter deposition area 3.

Specifically, the top of the structural cavity 4 is provided with a sealing film 5 that blocks the release hole.

Specifically, a vacuum cavity 6 is formed between the read-out circuit substrate 1 and the structural cavity 4 and the sealing film 5.

Specifically, the release hole includes a first release hole 401 located above the pixel area and a second release hole 302 located above the getter deposition area 3, the second release hole 302 being larger than the first release hole 401, and the getter body 301 one-to-one corresponding to the location and shape of the second release hole 302.

Furthermore, when the getter body 301 is placed in the getter deposition area 3, a shielding baffle 7 is arranged on the top of the structural cavity 4 to block the first release hole 401. When the getter body 301 is deposited into the getter deposition area 3 through the second release hole 302, the shielding baffle 7 is removed and the vacuum cavity 6 is sealed with a hole sealing film 5. The first release hole 401 is conveniently blocked by the shielding baffle 7, so that the getter body 301 is conveniently positioned and deposited through the second release hole 302 to complete the positioning of the getter body 301.

Furthermore, the structural cavity 4 and the shielding baffle 7 are combined by means of temporary bonding. After the shielding baffle 7 completes the positioning and deposition of the getter body 301 after the temporary bonding, it is convenient to remove and use the sealing film 5 to coat the film to complete the sealing of the vacuum cavity 6, and the sealing film 5 is an infrared antireflection film.

Specifically, the activation method of the getter body 301 is thermal activation, and the activation method of the getter body 301 is simple and easy to carry out batch production and manufacturing.

Specifically, the getter main body 301 adopts a physical vapor deposition process when depositing in the getter deposition area 3. Physical vapor deposition technology refers to the technology of gasification of the surface of a material source into gaseous atoms or molecules, or partial ionization into ions, under vacuum conditions, by physical methods, and deposition of films on the surface of the substrate through a low pressure gas or plasma process. Physical vapor deposition is one of the main surface treatment technologies.

Specifically, when the sealing film 5 is deposited on the structural cavity 4, the electron beam evaporation coating process is adopted, which is different from the traditional evaporation method. The combination of electromagnetic fields can accurately bombard the target in the Crucible with high-energy electrons, melt it and deposit it on the substrate. The electron beam evaporation can deposit high-purity and high-accuracy films, so as to ensure the good effect of the sealing film 5.

The embodiment of the invention also discloses a preparation method of an array level packaged uncooled infrared detector, which includes the following steps:
S1: divide the cell area and getter deposition area 3 on the substrate of the read-out circuit, prepare the active element 2 through the sacrificial layer in the cell area on the substrate 1 of the read-out circuit, and make a structural cavity covered on the substrate 1 of the read-out circuit, and make a sacrificial layer release hole on the structural cavity to complete the release of the sacrificial layer;
S2: combining the vacuum chamber 6 with the designed shielding baffle 7 by means of temporary bonding, and only opening the second release hole 302 at the position of the getter deposition area 3;
S3: The getter body 301 is made on the structure completed in step S2, and in the unobstructed area, the air intake will be deposited into the vacuum chamber 6 through the second release hole 302;
S4: After the deposition of the getter body 301 is completed, the shielding baffle 7 is removed;
S5: The sealing hole film 5 is plated on the structural cavity to complete the sealing of the vacuum cavity 6, and the getter body 301 is activated by heating.

The method for preparing the getter body 301 of the array level packaged uncooled infrared detector is as follows: after the structural sacrificial layer is released, a temporary bonding process is carried out between the getter body 301 and the semiconductor structural cavity 4 through the shielding baffle 7, only the getter deposition area 3 is opened, and the getter body 301 is deposited into the getter deposition area 3 and the vacuum cavity 6 through the coating process;
The invention opens a separate area for the getter main body 301, deposits the getter main body 301 after the release of the structural sacrifice layer, and designs the preparation process link of the getter main body 301 at the last stage of the whole set of mems processes, so as to avoid the impact of the previous processes on the production of the getter main body 301, that is, to avoid the impact of high temperature and organic solution in the process of mems technology on the performance of the getter main body 301, and adopts thermal activation. The activation mode of the getter main body 301 is simple and easy to carry out batch production and manufacturing.

It should be noted that, in this context, relationship terms such as first and second are used only to distinguish one entity or operation from another entity or operation, and do not necessarily require or imply any such actual relationship or order between these entities or operations. Moreover, the terms "including", "including" or any other variant thereof are intended to cover non-exclusive inclusion so that a process, method, article or device comprising a series of elements includes not only those elements, but also other elements that are not explicitly listed or are inherent to such a process, method, article or device. Without further restriction, the element defined by the statement "including a" does not preclude the existence of another identical element in the process, method, article or device including the element.

The basic principles and main features of the invention and the advantages of the invention are shown and described above. Those skilled in the art should understand that the present invention is not limited by the above-mentioned examples, and what is described in the above-mentioned examples and specifications is only to explain the principle of the present invention. Without departing from the spirit and scope of the present invention, there are also various changes and improvements in the present invention, which fall within the scope of the claimed invention. The scope of protection claimed by the invention is defined by the appended claims and their equivalents.

## Claims

1. An area array level packaged uncooled infrared detector, which is **characterized in that** it includes a read-out circuit substrate (1), the read-out circuit substrate (1) is provided with a pixels area, the pixels area is provided with active elements (2) electrically connected with the read-out circuit substrate (1), the read-out circuit substrate (1) is also provided with an getter deposition area (3), the getter deposition area (3) is provided with an getter body (301), the top of the read-out circuit substrate (1) is provided with a structural cavity (4), the structural cavity (4) is provided with a release hole, and the getter body (301) corresponding to a release hole located above the getter deposit area (3).

2. The plane array level packaged uncooled infrared detector according to claim 1, which is **characterized in that** a sealing film (5) is arranged on the top of the structural cavity (4) to block the release hole, and a vacuum cavity (6) is formed between the read-out circuit substrate (1), the structural cavity (4) and the sealing film (5).

3. The array level packaged uncooled infrared detector according to claim 1, which is **characterized in that** the release hole includes a first release hole (401) located above the pixel area and a second release hole (302) located above the getter deposition area (3), the second release hole (302) is larger than the first release hole (401), and the getter body (301) corresponds one-to-one with the location and shape of the second release hole (302).

4. A method for preparing an array level packaged uncooled infrared detector, which is **characterized in that** it includes the following steps:
S1: dividing the element area and the getter deposition area (3) on the substrate of the read-out circuit, preparing the active element (2) through the sacrificial layer in the element area on the substrate (1) of the read-out circuit, and making a structural cavity covered on the substrate (1) of the read-out circuit, and making a sacrificial layer release hole on the structural cavity to complete the release of the sacrificial layer;
S2: shielding the release hole (401) located above the pixel area, and only opening the release hole (302) located above the getter deposition area (3);
S3: The getter material is deposited on the structure fabricated in step S2, and the getter material is deposited through the release hole (302) above the getter deposition area (3) to the getter deposition area (3), forming the getter body (301);
S4: After the deposition of the getter body (301) is completed, the release hole (401) located above the pixel area is opened;
S5: The sealing hole film (5) is plated on the structural cavity to complete the sealing of the vacuum cavity (6), and the getter body (301) is activated by heating.

5. The method for preparing an area array level packaged uncooled infrared detector according to claim 4, which is **characterized in that** when the getter deposition area (3) is placed into the getter body (301), a shielding baffle (7) is arranged at the top of the structural cavity (4) to block the release hole (401) located above the image element area. When the getter body (301) is deposited into the getter deposition area (3) through the release hole (302) located above the getter deposition area (3), the shielding baffle (7) is removed and the vacuum cavity (6) is sealed with a hole sealing film (5).

6. The method for preparing an array level packaged uncooled infrared detector according to claim 5, which is **characterized in that** the sealing film (5) is an infrared antireflection film.

7. The method for preparing an array level packaged uncooled infrared detector according to claim 5, which is **characterized in that** the structural cavity (4) and the shielding baffle (7) are combined by temporary bonding.

8. The method for preparing an array level packaged uncooled infrared detector according to claim 4, which is **characterized in that** the getter body (301) adopts a physical vapor deposition process when depositing in the getter deposition area (3).

9. The method for preparing an array level packaged uncooled infrared detector according to claim 5, which is **characterized in that** the sealing film (5) is coated on the structural cavity (4) by an electron beam evaporation coating process.

10. The method for preparing an array level packaged uncooled infrared detector according to claim 4, which is **characterized in that** the getter deposition area (3) is arranged inside the vacuum chamber (6).
